# EUROPÄISCHE PATENTSCHRIFT

(11) **EP 1 203 408 B1**
(45) Veröffentlichungstag und Bekanntmachung des Hinweises auf die Patenterteilung: **23.05.2007**
(21) Anmeldenummer: 00949126.7
(22) Anmeldetag: 24.06.2000
(51) Int. Cl.: H01L 29/739

(54) **BIDIREKTIONALES HALBLEITERBAUELEMENT**
BI-DIRECTIONAL SEMICONDUCTOR COMPONENT
COMPOSANT SEMI-CONDUCTEUR BIDIRECTIONNEL

(30) Priorität: 20.07.1999 DE 19933969
(43) Veröffentlichungstag der Anmeldung: 08.05.2002
(73) Patentinhaber: ROBERT BOSCH GMBH, 70442 Stuttgart (DE)
(72) Erfinder: PLIKAT, Robert, D-72800 Eningen (DE); FEILER, Wolfgang, D-72766 Reutlingen (DE)
(86) Internationale Anmeldenummer: PCT/DE2000/002061
(87) Internationale Veröffentlichungsnummer: WO 2001/006567

(56) Entgegenhaltungen:
- EP-A- 0 848 161
- US-A- 5 793 064
- XU S ET AL: "BIDIRECTIONAL LIGBT ON SOI SUBSTRATE WITH HIGH FREQUENCY AND HIGH TEMPERATURE CAPABILITY" IEEE INTERNATIONAL SYMPOSIUM ON POWER SEMICONDUCTOR DEVICES AND ICS,US,NEW YORK, NY: IEEE, Bd. CONF. 9, 26. Mai 1997 (1997-05-26), Seiten 37-40, XP000800152 ISBN: 0-7803-3994-0 in der Anmeldung erwähnt

## Beschreibung

Die Erfindung betrifft ein bidirektionales Halbleiterbauelement, mit zwei lateral in einem Substrat integrierten, antiseriell geschalteten, symmetrischen MOS-Transistorstrukturen, deren Drainanschlüsse miteinander verbunden sind.

### Stand der Technik

Bidirektionale Halbleiterbauelemente der gattungsgemäßen Art sind bekannt. In IEEE; 2/97; S. Xu u.a. ; "Bidirectional LIGBT on SOI substrate with high frequency and high temperature capability" sind die gattungsgemäßen Halbleiterbauelemente beschrieben.

Ferner ist aus dem US-A-5 793 064 einen symmetrischen, bidirektionalen LIGBT bekannt, welcher einen hochdotierten Bereich im Draingebiet und ein dotiertes Substrat aufweist.

Durch den dort beschriebenen vollkommen symmetrischen Aufbau in Verbindung mit der antiseriellen Verschaltung der MOS-Transistoren ist das bekannte bidirektionale Halbleiterbauelement geeignet, als Matrixumschalter in Telekommunikationsanlagen oder dergleichen eingesetzt zu werden. Unsymmetrische Anwendungen, wie diese beispielsweise in Ansteuerschaltungen von Zündanlagen in Kraftfahrzeugen gegeben sind, lassen sich durch die bekannten bidirektionalen Halbleiterbauelemente nicht realisieren, da sich die erforderliche Sperrfähigkeit von zirka 400 V zur Zeit nur unsymmetrisch darstellen läßt.

### Vorteile der Erfindung

Das erfindungsgemäße bidirektionale Halbleiterbauelement bietet demgegenüber den Vorteil, daß auch unterschiedlich hohe Sperrspannungen realisiert werden können. Dadurch, daß einem pn-.Übergang eines einzigen der beiden MOS-Transistoren in einem Übergangsbereich zum Draingebiet eine Zone vorgelagert ist, die den gleichen Leitfähigkeitstyp wie das Draingebiet besitzt, deren Dotierung jedoch höher ist als die des Draingebietes, kann in einfacher Weise eine unsymmetrische Sperrfähigkeit bei gleichzeitiger Gewährleistung einer Niederohmigkeit im Einschaltfalle realisiert werden.

Durch die mit der erfindungsgemäßen Ausgestaltung des bidirektionalen Halbleiterbauelementes erzielbaren Vorteile eignet sich dieses bevorzugt zur Verwendung als Kurzschlußschalter zum Kurzschließen einer Primärwicklung einer Zündspule, in einer Zündanlage eines Kraftfahrzeuges. Es ist bekannt, daß bei einer Ionenstromzündung die Primärwicklung der Zündspule nach Auslösen des Zündimpulses an einer Zündkerze durch die Sekundärwicklung der Zündspule kurzzuschließen ist, da hierdurch ein Erlöschen des Zündfunkens definiert wird. Bei dieser erfindungsgemäß vorgesehenen Verwendung wird das als Kurzschlußschalter eingesetzte bidirektionale Halbleiterbauelement von unterschiedlich großen Sperrspannungen, nämlich einerseits der Batteriespannung und andererseits der Klammerspannung einer zum Beispiel als Darlington geschalteten Transistorstufe, beaufschlagt. Entsprechend der bei dem erfindungsgemäßen bidirektionalen Halbleiterbauelement vorgesehenen Pufferung des pn-Übergangs des einen MOS-Transistors läßt sich eine unsymmetrische Sperrfähigkeit des Halbleiterbauelements erzielen, mittels dem die unterschiedlich hohen Sperrspannungen ausgeglichen werden können.

Weitere bevorzugte Ausgestaltungen der Erfindung ergeben sich aus den übrigen, in den Unteransprüchen genannten Merkmalen.

### Zeichnungen

Die Erfindung wird nachfolgend in einem Ausführungsbeispiel anhand der zugehörigen Zeichnungen näher erläutert. Es zeigen:
- Figur 1: eine schematische Ansicht eines erfindungsgemäßen bidirektionalen Halbleiterbauelementes;
- Figur 2: eine Schaltungsanordnung einer Zündendstufe unter Verwendung des erfindungsgemäßen bidirektionalen Halbleiterbauelementes;
- ) Figur 3: eine bevorzugte Ausführungsform des erfindungsgemäßen bidirektionalen Halbleiterbauelementes und
- Figuren 4 und 5: schematische Prozeßschritte zur Herstellung des erfindungsgemäßen bidirektionalen Halbleiterbauelementes.

### Beschreibung des Ausführungsbeispiels

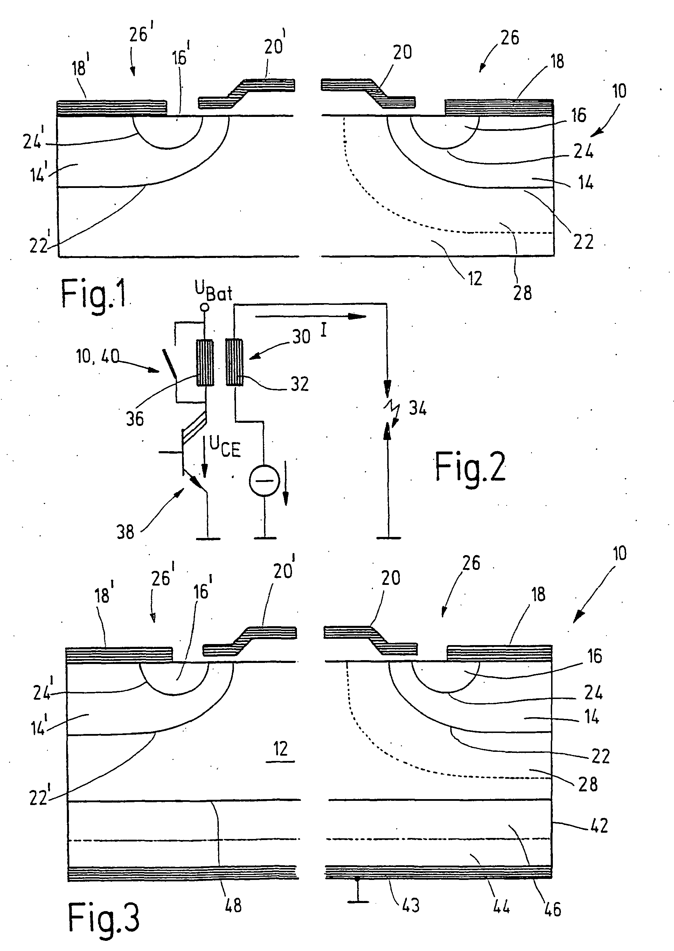

Figur 1 zeigt schematisch ein bidirektionales Halbleiterbauelement 10. Das bidirektionale Halbleiterbauelement 10 umfaßt ein Substrat 12 mit einer ersten Ladungsträgerdotierung (beispielsweise n-dotiert). In das Substrat 12 sind Ladungsträgergebiete 14 beziehungsweise 14' mit einer zur ersten Ladungsträgerdotierung entgegengesetzten Ladungsträgerdotierung (beispielsweise p-dotiert) integriert. Die Ladungsträgergebiete 14 und 14' sind symmetrisch ausgebildet. In die Ladungsträgergebiete 14 beziehungsweise 14' sind jeweils Ladungsträgergebiete 16 beziehungsweise 16' integriert, die die gleiche Ladungsträgerdotierung wie das Substrat 12 (beispielsweise n-dotiert) aufweisen. Die Ladungsträgergebiete 14 und 16 sind mit einer gemeinsamen Metallisierung (Elektrode) 18 und die Ladungsträgergebiete 14' und 16' mit einer gemeinsamen Metallisierung (Elektrode) 18' elektrisch leitend verbunden. Das Ladungsträgergebiet 14 ist ferner mit einer weiteren isolierten Elektrode (Poly-Si-Gate) .20 versehen, und das Ladungsträgergebiet 14' ist mit einer weiteren isolierten Elektrode (Poly-Si-Gate) 20' versehen.

Durch Anordnung der Ladungsträgergebiete 12, 14 und 16 beziehungsweise 12, 14' und 16' kommt es zur Ausbildung von pn-Übergängen 22 beziehungsweise 22' und 24 beziehungsweise 24'.

Das Substrat 12 des ersten Leitfähigkeitstypes ist schwachdotiert, während das Ladungsträgergebiet 16 beziehungsweise 16' des gleichen Leitfähigkeitstypes stark dotiert ist. Das Ladungsträgergebiet 14 beziehungsweise 14' des anderen Leitfähigkeitstypes ist mitteldotiert. Durch eine derartige, an sich bekannte Struktur des Halbleiterbauelementes 10 kommt es zur Ausbildung von zwei MOS-Transistoren 26 beziehungsweise 26', die antiseriell geschaltet sind.

Zusätzlich ist dem pn-Übergang 22 ein Ladungsträgergebiet 28 zugeordnet, das sich in das Substrat 12 hinein erstreckt. Das Ladungsträgergebiet 28 besitzt Ladungsträger des gleichen Leitfähigkeitstyps wie das Substrat 12, ist jedoch höher dotiert als dieses.

Eine erfindungsgemäße Verwendung des Halbleiterbauelementes 10 ist anhand der in Figur 2 gezeigten Schaltungsanordnung verdeutlicht, die eine Zündendstufe einer Zündanlage eines Kraftfahrzeuges zeigt. Hierbei ist eine Sekundärwicklung 32 einer Zündspule 30 mit einer Zündkerze 34 verbunden. Die Primärwicklung 36 der Zündspule 30 ist einerseits mit einer Versorgungsspannungsquelle verbunden, die im Anwendungsfall von der Kraftfahrzeugbatterie gebildet ist. Andererseits ist die Primärwicklung 36 mit einem Schaltelement 38 verbunden, über das die Primärwicklung 36 mit der Versorgungsspannungsquelle verbindbar ist. Das Schaltelement 38 ist zum Beispiel als Darlington-Transistorstufe ausgebildet. Parallel zur Primärwicklung 36 ist ein Kurzschlußschalter 40 angeordnet, der von dem erfindungsgemäßen bidirektionalen Halbleiterbauelement 10 gebildet ist. Die Metallisierung 18 ist hierbei mit dem Schaltelement 38 und die Metallisierung 18' mit der Versorgungsspannungsquelle verbunden.

Das Halbleiterbauelement 10 zeigt in Verbindung mit der in Figur 2 dargestellten Schaltungsanordnung folgende Funktion:

Mittels der Zündkerze 34 kann in bekannter Weise ein Kraftstoff-Luft-Gemisch in einem Zylinder einer Verbrennungskraftmaschine gezündet werden. Nach Erlöschen des Zündfunkens ist das Gasgemisch im Zylinder noch ionisiert. Eine hier vorhandene Ionenkonzentration ermöglicht in bekannter Weise Rückschlüsse auf das Verbrennungs- und Klopfverhalten der Verbrennungskraftmaschine. Es ist bekannt, zur Bestimmung dieser Ionenkonzentration an die Elektroden der Zündkerze 34 eine Beschleunigungsspannung anzulegen, so daß ein hieraus resultierender Ionenstrom I ein Maß für die Ionenkonzentration bildet. Wesentlich für ein derartiges Verfahren zur Bestimmung der Ionenkonzentration ist, daß der Zündfunken nach Zündung des Kraftstoff-Luft-Gemisches definiert gelöscht wird und unmittelbar anschließend die Messung des Ionenstroms I erfolgt.

Diese Voraussetzungen können durch ein niederohmiges Kurzschließen der Primärwicklung 36 durch das erfindungsgemäße Halbleiterbauelement 10 (Schaltelement 40) erreicht werden. Der Kurzschluß der Primärwicklung 36 bewirkt einerseits ein definiertes Erlöschen des Zündfunkens nach Zündung des Kraftstoff-Luft-Gemisches und minimiert die transformierte Serienimpedanz in der Sekundärseite der Zündschaltung. Hierdurch wird das Frequenzverhalten des Meßkreises zum Messen des Ionenstromes I günstig beeinflußt.

Um das definierte Erlöschen des Zündfunkens zu erreichen, bedarf es eines definierten Schaltzeitpunktes des Halbleiterbauelementes 10 (Kurzschließer 40). Der Kurzschließer 40 liegt einerseits an der Versorgungsspannung U_{Bat} und andererseits an der Klammerspannung U_{CE} des Schalttransistors 38. Die Versorgungsspannung beträgt zirka 14 V, während die Klammerspannung U_{CE} zirka 400 V beträgt. Für diesen Spannungsunterschied muß das Halbleiterbauelement 10 eine Sperrfähigkeit von zirka 400 V aufweisen. Dies wird durch die erfindungsgemäß vorgesehene Integration des Ladungsträgergebietes 28 in das Halbleiterbauelement 10 erreicht.

Werden weder Poly-Si-Gate (Elektrode) 20 noch Poly-Si-Gate (Elektrode) 20' angesteuert, ist das Halbleiterbauelement 10 für beide Polaritäten gesperrt. Dieser Betriebszustand liegt vor, wenn die Primärwicklung 36 durch Ansteuern des Schalttransistors 38 bestromt wird. Die Elektroden 18' und 20' liegen in diesem Betriebszustand auf Versorgungsspannungsniveau, und der pn-Übergang 22 ist sperrgepolt. Die Dotierung der Ladungsträgergebiete 12 und 28, die dem pn-Übergang 22 vorgelagert sind, ist hierbei so gewählt, daß die notwendige Sperrspannung - bei anliegender Versorgungsspannung U_{Bat} - gegeben ist.

Schaltet der Zündtransistor 38 aus, geht dieser in die Klammerung, so daß in bekannter Weise der Zündfunke der Zündkerze 34 dann zündet. Die Klammerspannung U_{CE} beträgt zirka 400 V, so daß die Elektroden 18 und 20 mit der Klammerspannung auf den Wert von zirka 400 V hochlaufen. Das Halbleiterbauelement 10 muß also in der Lage sein, diese Klammerspannung zu sperren.

Zum Löschen des Zündfunkens der Zündkerze 34 wird das Halbleiterbauelement 10 (Kurzschließer 40) geschaltet, indem die Elektrode 20 angesteuert wird. Hierdurch wird das Halbleiterbauelement 10 zunächst als bidirektionales Schaltelement (IGBT) geschaltet. Die Spannung über dem Schalter (also zwischen den Elektroden 18 und 18') reduziert sich hierdurch auf die statische Durchlaßspannung des Halbleiterbauelementes 10, so daß mit einer Verzögerung auch die Elektrode 20 angesteuert werden kann. Hierdurch ändert sich der Betriebszustand des Halbleiterbauelementes 10 in den eines MOS-Transistors mit endlichem differentiellen Widerstand im Ursprung seiner Ausgangskennlinie.

Durch die Ansteuerung der Elektrode 20' (Gate für den MOS-Transistor 36') fließt ein Strom von der Elektrode 18' über das Ladungsträgergebiet 16' in das Substrat 12 (Draingebiet), so daß das Ladungsträgergebiet 14 als Emitter reagiert und Minoritätsladungsträger in das Substrat 12 initiiert. Hierdurch wird dessen Leitfähigkeit erhöht. Hieraus resultiert eine Reduktion des Spannungsabfalles über dem Halbleiterbauelement 10, so daß nachfolgend ohne Probleme die Elektrode 20, als Gate des MOS-Transistors 26, angesteuert werden kann. Hierdurch wird die Emitterwirkung des Ladungsträgergebietes 14 unterdrückt, da ein Parallelstrompfad von dem Substrat 12 (Drain) über das Ladungsträgergebiet 14 zum Ladungsträgergebiet 16 aufgebaut wird. Dies führt zum Kippen des Betriebszustandes des Halbleiterbauelementes 10 von einem bidirektionalen Bauelement (IGBT) in den Betriebszustand eines MOS-Transistors mit ausreichender Leitfähigkeit.

Die Ansteuerung der Elektrode 20 kann entweder gleichzeitig mit Ansteuerung der Elektrode 20' unter Zwischenschaltung einer Kapazität erfolgen, oder die Ansteuerung der Elektrode 20 erfolgt direkt zeitversetzt zu der Ansteuerung der. Elektrode 20'. In jedem Falle wird erreicht, daß eine Ansteuerung des Gate-Anschlusses des MOS-Transistors 26 hierdurch erfolgt, nachdem die Klammerspannung U_{CE} bereits reduziert ist. Alles in allem wird hiermit durch ein definiertes Ansteuern der Elektrode 20' und der Elektrode 20 ein definiertes Schalten des Halbleiterbauelementes 10 als Kurzschließer 40 möglich, so daß ein definiertes Ausschalten des Zündfunkens der Zündkerze 34 erfolgt.

Figur 3 zeigt eine bevorzugte Ausführungsvariante des Halbleiterbauelementes 10, wobei gleiche Teile wie in Figur 1 mit gleichen Bezugszeichen versehen und nicht nochmals erläutert sind.

Wie Figur 3 zeigt, ist das Substrat 12 auf einer Schicht 42 angeordnet, die eine entgegengesetzte Dotierung zu dem Substrat 12 (gemäß Beispiel also pDotierung) besitzt, an dem Massepotential 43 angeschlossen ist. Die Schicht 42 kann aus Teilschichten 44 und 46 bestehen, die eine unterschiedlich hohe Ladungsträgerdotierung des gleichen Leitfähigkeitstyps besitzen. Durch Anordnung der Schicht 42 kommt es zur Ausbildung eines weiteren pn-Übergangs 48, dessen Sperrspannung durch die Dotierung der Schicht 42 bestimmt ist. Durch die stufenweise Dotierung der Schichten 44 und 46 kann die Sperrspannung durch Nutzung des Resurf-Effektes erhöht werden.

Durch die in Figur 3 gezeigte Strukturierung des Halbleiterbauelementes 10 wird die Realisierung einer sogenannten Resurf-Technologie möglich, mittels der sich die Struktur des Halbleiterbauelementes 10 in einfacher Weise erzielen läßt.

Durch den monolitisch integrierten Aufbau des Halbleiterbauelementes 10, der den Kurzschließer 40 ausbildet, läßt sich dieser in einfacher Weise mit dem Schalttransistor 38 in einem monolitisch integrierten Bauelement unterbringen. Hierdurch kann auf die Anordnung diskreter Schaltelemente verzichtet werden. Hierdurch ergeben sich wesentliche Fertigungsvorteile für die gesamte Zündschaltung.

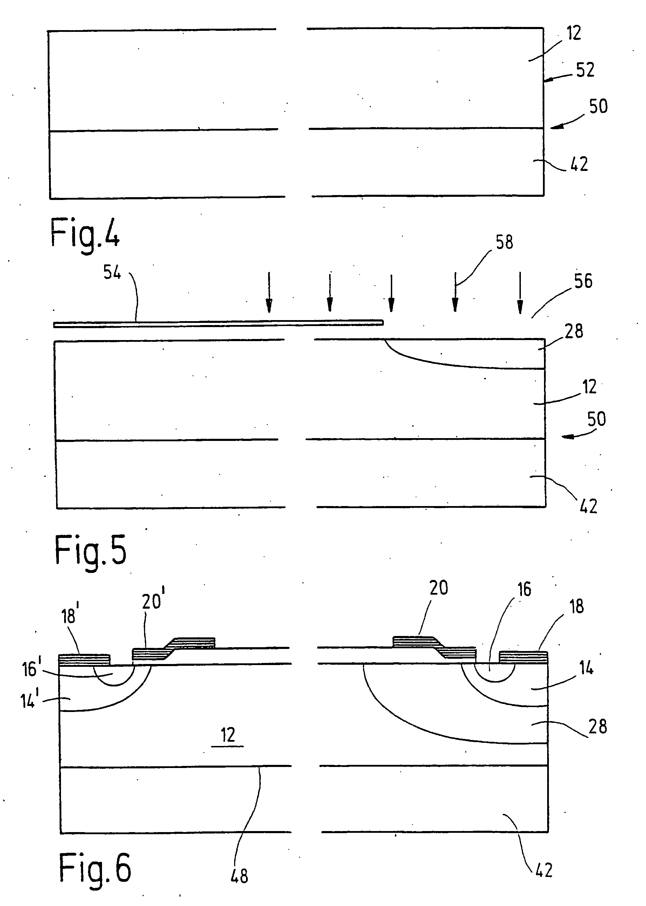

Anhand der Figuren 4 bis 6 wird schematisch der Herstellungsprozeß des Halbleiterbauelementes 10 verdeutlicht.

Zunächst wird, wie Figur 4 verdeutlicht, auf einem Ausgangswafer 50, der eine p-Dotierung entsprechend der Dotierung der späteren Schicht 42 besitzt, eine n-dotierte Driftschicht mittels Implantation eingebracht. Diese n-dotierte Driftschicht 52 entspricht dem späteren Substrat 12. Diese Prozessierung ist durch einen sogenannten Standard-Smart-Power-Prozeß bekannt.

Anschließend wird, wie Figur 5 verdeutlicht, über den Ausgangswafer 50 eine Maskierung 54 angeordnet, die im Bereich des späteren Ladungsträgergebietes 28 eine Maskenöffnung 56 aufweist. Anschließend erfolgt eine Ionenimplantation 58 mit n-dotierten Ionen, die zur Ausbildung des Ladungsträgergebietes 28 innerhalb des n-dotierten Substrates führt, wobei das Ladungsträ-7 gergebiet 28 eine höhere Dotierung als das Substrat 12 aufweist.

Nachfolgend werden in nicht näher gezeigten verfahrensschritten, die allesamt Standardprozeßschritte aus der Fertigung integrierter Schaltungen sind, die Ladungsträgergebiete 14, 14' beziehungsweise 16, 16' implantiert und die Elektroden 18, 18', 20 und 20' aufgebracht. Gleichzeitig werden nicht näher dargestellte weitere Schaltungsbestandteile, beispielsweise die Steuerlogik für die Ansteuerung der Elektroden 20, 20', Passivierungsschichten, Polysiliziumschichten usw. erzeugt.

## Patentansprüche

1. Bidirektionales Halbleiterbauelement, mit zwei lateral in einem Substrat integrierten, antiseriell geschalteten, symmetrischen MOS-Transistorstrukturen, deren Drainanschlüsse miteinander verbunden sind, **dadurch gekennzeichnet, daß** einem pn-Übergang (22) eines einzigen der beiden MOS-Transistoren (26) in einem Übergangsbereich zum Draingebiet (12) eine Zone (28) vorgelagert ist, die den gleichen Leitfähigkeitstyp wie das Draingebiet besitzt, deren Dotierung jedoch höher ist als die Dotierung des Draingebietes (12).

2. Bidirektionales Halbleiterbauelement nach Anspruch 1, **dadurch gekennzeichnet, daß** Draingebiet (12) und Zone (28) n-dotiert sind.

3. Bidirektionales Halbleiterbauelement nach einem der vorhergehenden Ansprüche, **dadurch gekennzeichnet, daß** das Draingebiet (12) auf einer Schicht (42) angeordnet ist, die eine Dotierung mit entgegengesetztem Leitfähigkeitstyp wie das Draingebiet (12) aufweist.

4. Bidirektionales Halbleiterbauelement nach Anspruch 3, **dadurch gekennzeichnet, daß** die Schicht (42) aus Teilschichten (44, 46) mit gestufter Dotierung besteht.

5. Verwendung eines bidirektionalen Halbleiterbauelementes nach einem der Ansprüche 1 bis 4 als Kurzschließschalter (40) zum Kurzschließen einer Primärwicklung (36) einer Zündspule (30) in einer Zündendstufe einer Zündanlage einer Verbrennungskraftmaschine.

6. Verwendung nach Anspruch 5, **gekennzeichnet durch** eine zeitversetzte Ansteuerung der Gateanschlüsse (20, 20') der MOS-Transistorstrukturen (26, 26'), wobei der MOS-Transistor (26), der eine höhere Spannung (U_{CE}) sperrt, später angesteuert wird.

7. Verwendung nach Anspruch 6, **dadurch gekennzeichnet, daß** die zeitversetzte Ansteuerung durch Zwischenschaltung einer Kapazität erfolgt.

8. Verwendung nach Anspruch 6, **dadurch gekennzeichnet, daß** die zeitversetzte Ansteuerung durch eine Zeitsteuerung erfolgt.

## Claims

1. Bidirectional semiconductor component, comprising two symmetrical MOS transistor structures which are integrated laterally in a substrate and are reverse-connected in series and the drain terminals of which are connected to one another, **characterized in that** a pn junction (22) of a single one of the two MOS transistors (26), in a transition region to the drain region (12), is preceded by a zone (28) which has the same conductivity type as the drain region but whose doping is higher than the doping of the drain region (12).

2. Bidirectional semiconductor component according to Claim 1, **characterized in that** drain region (12) and zone (28) are n-doped.

3. Bidirectional semiconductor component according to one of the preceding claims, **characterized in that** the drain region (12) is arranged on a layer (42) which has a doping having an opposite conductivity type to that of the drain region (12).

4. Bidirectional semiconductor component according to Claim 3, **characterized in that** the layer (42) comprises partial layers (44, 46) having stepped doping.

5. Use of a bidirectional semiconductor component according to one of Claims 1 to 4 as a short-circuiting switch (40) for short-circuiting a primary winding (36) of an ignition coil (30) in an ignition output stage of an ignition system of an internal combustion engine.

6. Use according to Claim 5, **characterized by** a time-staggered driving of the gate terminals (20, 20') of the MOS transistor structures (26, 26'), the MOS transistor (26) that blocks a higher voltage (U_{CE}) being driven later.

7. Use according to Claim 6, **characterized in that** the time-staggered driving is effected by interposition of a capacitance.

8. Use according to Claim 6, **characterized in that** the time-staggered driving is effected by a time control.

## Revendications

1. Composant semi-conducteur bidirectionnel, pourvu de deux structures de transistor MOS symétriques en montage tête-bêche, intégrées latéralement dans un substrat et dont les connexions de drain sont reliées l'une à l'autre,
**caractérisé en ce qu'**
une zone (28) présentant le même type de conductivité que la zone de drain mais dont le dopage est supérieur au dopage de la zone de drain (12) est placée en amont d'une jonction pn (22) d'un seul des deux transistors MOS (26) dans une zone de jonction à la zone de drain (12).

2. Composant semi-conducteur bidirectionnel selon la revendication 1,
**caractérisé en ce que**
la zone de drain (12) et la zone (28) sont dopées n.

3. Composant semi-conducteur bidirectionnel selon l'une des revendications précédentes,
**caractérisé en ce que**
la zone de drain (12) est disposée sur une couche (42) qui a un dopage dont le type de conductivité est opposé à celui de la zone de drain (12).

4. Composant semi-conducteur bidirectionnel selon la revendication 3,
**caractérisé en ce que**
la couche (42) se compose de couches partielles (44, 46) à dopage étagé.

5. Utilisation d'un composant semi-conducteur bidirectionnel selon l'une des revendications 1 à 4, comme commutateur de court-circuit (40) pour court-circuiter une bobine primaire (36) d'une bobine d'allumage (30) dans un étage de sortie d'un dispositif d'allumage d'un moteur à combustion interne.

6. Utilisation selon la revendication 5,
**caractérisée par**
une commande différée des connexions de grille (20, 20') des structures de transistor MOS (26, 26'), en commandant plus tard le transistor MOS (26), qui bloque une tension supérieure (U_{CE}).

7. Utilisation selon la revendication 6,
**caractérisée en ce que**
la commande différée se produit par l'intermédiaire d'une capacité.

8. Utilisation selon la revendication 6,
**caractérisée en ce que**
la commande différée est produite par un dispositif de commande chronologique.
